Europäisches Patentamt

European Patent Office

Office européen des brevets

(19)

(11) Numéro de publication: **0 161 963 B1**

## (12) FASCICULE DE BREVET EUROPEEN

(45) Date de publication de fascicule du brevet:
09.10.91

(51) Int. Cl.⁵: **H03M 1/44**, H03M 1/00

(21) Numéro de dépôt: 85400733.3

(22) Date de dépôt: **12.04.85**

(54) **Convertisseur analogique-numérique très rapide de type dichotomique.**

(30) Priorité: **19.04.84 FR 8406233**

(43) Date de publication de la demande:
**21.11.85 Bulletin 85/47**

(45) Mention de la délivrance du brevet:
**09.10.91 Bulletin 91/41**

(84) Etats contractants désignés:
**DE FR GB IT NL**

(56) Documents cités:
**DE-A- 2 645 606**
**GB-A- 1 266 962**
**GB-A- 1 601 115**

(73) Titulaire: **CENTRE NATIONAL DE LA RECHER-CHE SCIENTIFIQUE (CNRS)**
**15, Quai Anatole France**
**F-75700 Paris Cedex 07(FR)**

(72) Inventeur: **Marbot, Roland**
**58, rue Pierre Curie**
**F-78470 Saint Remy Les Chevreuse(FR)**
Inventeur: **Polonovski, Jean-Pierre**
**La Châtaigneraie Tour d'Echelle du Mur de la Forêt**
**F-78750 Mareil-Marly(FR)**

(74) Mandataire: **Mongrédien, André et al**
**c/o BREVATOME 25, rue de Ponthieu**
**F-75008 Paris(FR)**

## Description

L'invention a pour objet un convertisseur analogique-numérique à N bits très rapide de type dichotomique.

Un convertisseur analogique-numérique est un circuit intégré qui peut être réalisé aussi bien en technologie bipolaire qu'en technologie MOSFET, MESFET ou JFET sur substrat silicium ou arséniure de gallium.

Les convertisseurs analogiques-numériques très rapides sont apparus il y a quelques années et, depuis lors, leur utilisation s'est largement répandue aidée en cela par la tendance générale à traiter numériquement les signaux analogiques. On peut notamment citer comme domaines d'utilisation de tels convertisseurs la télévision numérique, l'oscilloscopie numérique et de manière générale tous les domaines de traitement de signaux de haute fréquence (radar, imagerie,...).

Ces circuits permettent de convertir et d'échantillonner à fréquence élevée un signal analogique.

A ce jour, on peut trouver des composants dont la fréquence d'échantillonnage peut atteindre 20 MHz pour un circuit en technologie MOS et 100 MHz pour un circuit en technologie bipolaire. La résolution des circuits connus est en général limitée à 8 bits.

Une méthode classique de conversion analogique-numérique consiste à comparer un signal de tension V à numériser à $2^N$ signaux de référence découpant régulièrement la gamme $[V_o-V_{ref}, V_o+V_{ref}]$ des tensions admissibles, N exprimant la résolution en nombre de bits, puis à encoder prioritairement les sorties des $2^N$ comparateurs pour produire un signal numérique de N bits.

Cette méthode conduit à deux limitations. D'une part, la résolution excède rarement 8 bits car une telle résolution nécessite déjà $2^8$ soit 256 comparateurs. D'autre part, la bande passante est limitée par le fait qu'il faut distribuer le signal d'entrée V sur chacun des comparateurs, ce qui rend nécessaire l'utilisation d'un amplificateur externe.

Les performances d'un convertisseur analogique-numérique basé sur cette méthode sont également limitées par des difficultés d'ordre technologique dans :

- la réalisation d'un réseau résistif très précis pour produire les $2^N$ signaux de tension de référence,
- le contrôle de l'offset des comparateurs qui sans cela peut aboutir à donner des codes manquants, c'est-à-dire à l'impossibilité de délivrer un signal numérique donné quelle que soit la tension analogique V,
- le compromis entre la rapidité et la consommation des comparateurs.

On connaît également une méthode de conversion analogique-numérique qui donne des performances comparables à la première méthode, tout en diminuant le nombre de composants, donc la consommation. Cette méthode utilise le principe connu de dichotomie.

Un convertisseur analogique-numérique mettant en oeuvre cette méthode comprend un échantillonneur-bloqueur, recevant le signal de tension V à numériser, suivi de N cellules identiques en cascade. Chaque cellule comprend deux éléments :

- un comparateur recevant en entrée un signal analogique $V_e$ et un signal de référence $V_{ref}$,
- un amplificateur délivrant un signal $V_S$ égal à $2x |V_e-V_{ref}:2|$ .

Le signal $V_e$ reçu par une cellule est le signal $V_s$ de la cellule précédente ; pour la première cellule, c'est le signal V. L'ensemble des sorties des comparateurs forme la valeur numérisée en code de Gray du signal V échantillonné.

Cette méthode n'est pas sans inconvénients. En effet, dans chaque cellule, l'amplificateur applique un gain 2 au signal de haute fréquence $V_e-V_{ref}:2$. Ceci est lié au choix de l'utilisation d'un seuil de comparaison unique $V_{ref}:2$ pour toutes les cellules. Cette méthode conduit à une limitation des performances du convertisseur car la précision du gain de chaque amplificateur conditionne la résolution du convertisseur, et ceci dans toute la bande passante.

Par ailleurs, la rapidité du convertisseur dépend de la bande passante des amplificateurs et du temps de transit total des N cellules. En effet, on peut dire schématiquement que pendant que l'information se propage jusqu'au dernier bit, le signal d'entrée ne doit pas varier de plus de la valeur du bit de poids le plus faible ; ce qui nécessite l'emploi d'un échantillonneur-bloqueur qui, à partir d'un certain seuil de rapidité introduit à lui seul plus de limitations aux performances que le reste des moyens du convertisseur. Enfin, l'application d'un gain 2 précis à un signal de haute fréquence est délicate.

On connaît des convertisseurs analogiques-numériques de type dichotomique dans lesquels le signal de haute fréquence n'est pas multiplié mais dans lesquels, au contraire, le signal de référence, qui est constant, est divisé par 2 dans chaque cellule. De tels convertisseurs analogiques-numériques sont décrits notamment dans les demandes de brevet GB-A-1266962 et GB-A-1601115. Ils se composent d'une suite de cellules en cascade, chaque cellule comprenant un pont de diodes, la comparaison étant effectuée dans chaque cellule sur des signaux de courant et non plus des signaux de tension.

La réalisation d'un convertisseur analogique-numérique dans lequel la comparaison s'effectue sur des signaux de courant est délicate, notamment dans la mise en cascade des cellules. Cette difficulté est contournée, dans les demandes de brevet citées par l'utilisation d'un circuit intermédiaire travaillant en tension entre deux cellules consécutives.

Cependant, une autre difficulté réside en ce que les potentiels de sortie d'une cellule sont incompatibles avec les potentiels d'entrée de la cellule suivante. Ce problème est résolu par l'utilisation, en alternance, de cellules complémentaires. Cette solution implique donc l'utilisation, dans le circuit intermédiaire, de transistors de type NPN pour la conversion du signal sortant des ponts de diodes des cellules de rang pair (par exemple) et de transistors de type PNP pour la conversion du signal sortant des ponts de diodes des cellules de rang impair.

Cette structure à cellules complémentaires limite considérablement les performances du convertisseur analogique-numérique d'une part car la fréquence de coupure des transistors PNP est seulement de l'ordre du mégahertz, alors que la fréquence de coupure des transistors NPN est de l'ordre du gigahertz, et d'autre part car le gain en courant des transistors PNP est faible (entre 1 et 30 environ) ce qui pose un problème de compensation des courants de base des transistors en entrée du pont de diodes.

L'invention a pour objet un convertisseur analogique-numérique de type dichotomique palliant notamment les inconvénients des convertisseurs analogiques-numériques connus.

Le convertisseur de l'invention est caractérisé par l'absence de tension variable et par un traitement de l'information effectué uniquement sous forme de courant électrique. Ce traitement est rendu possible par l'emploi de moyens de liaisons disposés entre deux cellules consécutives et ayant pour rôle de limiter les excursions en tension. Ces moyens de liaison permettent de transmettre d'une cellule à l'autre le signal de courant sans transmettre les tensions.

Le traitement du signal sous forme de courant électrique sans conversion en tension entre deux cellules permet d'utiliser des cellules identiques et donc de supprimer les limitations de performances nées de l'emploi de cellules complémentaires.

De manière précise, l'objet de l'invention est un convertisseur analogique-numérique très rapide de type dichotomique tel que défini dans la revendication 1.

Par $|i_e|$, on note la valeur absolue de la quantité $i_e$. Les moyens de liaison ont pour rôle de limiter les excursions en tension dans le convertisseur. Le nombre de moyens de liaisons peut être nul, notamment si le nombre de cellules est faible.

On note que, dans le cas particulier où N est égal à 1, le convertisseur est un comparateur analogique très rapide.

Le moyen de comparaison de chaque cellule comprend un pont de diodes dont les points de potentiel haut et bas, c'est-à-dire respectivement le noeud du pont relié à la cathode de deux diodes et celui relié à l'anode de deux diodes, sont à des potentiels fixes $V_U$ et $V_D$ qui vérifient $V_U-V_D < 2.V_S$, où $V_S$ est la tension de seuil d'une diode du pont, et dont les points d'entrée, c'est-à-dire les deux noeuds symétriques du pont, reçoivent respectivement un courant $i_e$ et son opposé $-i_e$, le résultat de la comparaison à zéro étant indiqué par le potentiel d'un des points d'entrée et les courants $|i_e|$ et $-|i_e|$ apparaissant respectivement sur les points de potentiel bas et haut du pont.

Ce moyen réalise une comparaison à zéro analogique de grande précision et de très grande rapidité, en un temps de l'ordre de la nanoseconde. D'autre part, ce moyen est constitué d'éléments passifs et ne consomme donc pas de courant. En fait, la récupération du potentiel d'un des points d'entrée, qui détermine le résultat de la comparaison, nécessite un transistor donc un élément actif. La consommation de ce moyen reste cependant très faible.

Selon un mode préféré de réalisation du convertisseur de l'invention, les diodes des ponts sont de type Schottky. Ces diodes ont l'avantage d'avoir une faible tension de seuil, ce qui permet de limiter les excursions en tension dans le convertisseur et de ne pas présenter de phénomène de stockage de charges.

Selon une autre caractéristique, on choisit une différence de tension $V_U-V_D$ entre les points haut et bas d'un pont de diode égale à la tension de seuil $V_S$ d'une diode du pont. Ceci contribue également à limiter les excursions en tension.

Enfin, on prévoit des miroirs de courant dans chaque moyen de liaison pour transmettre d'une cellule à une autre cellule les courants analogiques sans transmettre les potentiels.

Selon un premier mode de réalisation, le convertisseur de l'invention comprend N-1 moyens de liaison intercalés entre les N cellules.

Le potentiel en un point d'entrée du pont de diodes de chaque cellule peut alors avoir deux valeurs qui sont liées aux potentiels $V_U$ et $V_D$. L'une de ces valeurs correspond à $i_e > 0$, l'autre à $i_e < 0$.

Le codeur numérique reçoit alors N signaux de tension binaire délivrés par les N moyens suiveurs des cellules, chacun de ces signaux correspondant à un état de potentiel du point d'entrée d'un pont de diodes d'une cellule.

Selon un second mode de réalisation, le convertisseur de l'invention comprend un moyen de liaison entre chaque cellule de rang pair et la cellule suivante.

Les points d'entrée du pont de diodes d'une cellule de rang pair sont alors directement reliés aux points haut et bas du pont de diodes de la cellule de rang précédent.

Dans ce convertisseur, le potentiel en un point d'entrée d'un pont de diodes de rang pair peut prendre quatre valeurs. Le potentiel en ce point peut donc être représenté par le codeur numérique par deux signaux binaires. L'un de ces signaux indique le signe du courant $i_e$ et l'autre le signe du courant $|i_e|- I_e:2$. Le codeur numérique reçoit donc des signaux quadrivalués de chaque moyen suiveur des cellules placées en amont d'un moyen de liaison.

Les caractéristiques et avantages de l'invention ressortiront mieux de la description qui va suivre, donnée à titre illustratif mais non limitatif, en référence aux dessins annexés dans lesquels :

- la figure 1 est une représentation schématique d'un convertisseur analogique-numérique selon l'invention.
- la figure 2 illustre le fonctionnement du moyen de comparaison à zéro et d'obtention de la valeur absolue d'un courant de chaque cellule du convertisseur de la figure 1,
- la figure 3 est un mode de réalisation de l'étage d'entrée du convertisseur de la figure 1,
- la figure 4 est un mode de réalisation d'une cellule du convertisseur de la figure 1,
- la figure 5 illustre la mise en cascade de deux cellules du convertisseur, sans moyen de liaison entre elles,
- la figure 6 représente un miroir de courant d'un moyen de liaison selon un premier mode de réalisation,
- la figure 7 représente un miroir de courant d'un moyen de liaison selon un second mode de réalisation,
- la figure 8 représente le moyen de comparaison à zéro et d'obtention de la valeur absolue d'une cellule relié à deux miroirs de courant et à deux moyens suiveurs.

Dans la suite du texte, le moyen de comparaison à zéro et d'obtention de la valeur absolue d'un courant est désigné simplement par moyen de comparaison pour abréger.

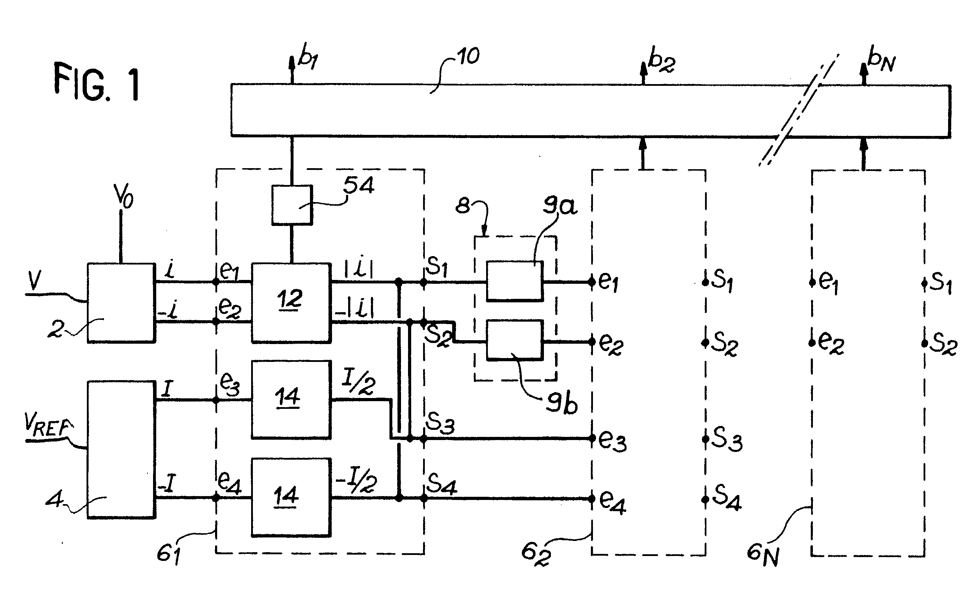

On a représenté sur la figure 1 un dessin schématique du convertisseur analogique-numérique de l'invention. Il comprend un étage d'entrée 2, une source de courant 4, une suite de cellules identiques $6_1$, $6_2$, ..., $6_{N-1}$, une cellule terminale $6_N$, un ou plusieurs moyens de liaison 8 entre deux cellules consécutives et un codeur numérique 10.

Le convertisseur de l'invention est composé d'un ensemble de cellules identiques en cascade, chaque cellule délivrant un élément binaire, ou bit. La juxtaposition des bits délivrés par les cellules forme un signal numérique dont la valeur représente, en code de Gray, la valeur numérique associée au signal analogique reçu.

On notera que le convertisseur de l'invention peut être utilisé comme multiplicateur de fréquence. En effet, si on applique en entrée un signal triangulaire périodique de fréquence f, le signal binaire délivré par la $n^{ième}$ cellule est un signal périodique de fréquence nf.

Le convertisseur analogique-numérique de la figure 1 délivre un signal numérique de N bits $b_1$, $b_2$, ..., $b_N$ correspondant au signal analogique reçu, chaque cellule contribuant pour un bit au signal numérique délivré. L'étage d'entrée 2 reçoit en entrée le signal analogique de tension V à numériser. Ce signal appartient à l'intervalle $|V_0-V_{ref}, V_0 + V_{ref}|$. L'étage d'entrée 2 délivre un courant analogique i, et son opposé -i, en fonction de l'amplitude du signal de tension V par rapport à $V_0$. La source de courant 4 délivre un courant de référence I, et son opposé -I, dont l'intensité est égale au signal de courant que délivrerait la source de tension 2 si le signal de tension reçu en entrée était égal à $V_{ref}$. Ces 4 signaux de courant sont appliqués sur les quatre entrées de la première cellule $6_1$.

Cette cellule, comme chacune des autres cellules, sauf la cellule terminale, possède quatre entrées $e_1$, $e_2$, $e_3$ et $e_4$ et quatre sorties $s_1$, $s_2$, $s_3$, et $s_4$. Chacune des N-1 premières cellules reçoit sur son entrée $e_1$ un courant analogique et sur son entrée $e_2$ le courant analogique opposé, sur son entrée $e_3$ un courant de référence et sur son entrée $e_4$ le courant de référence opposé.

Chacune des N-1 premières cellules comprend trois moyens de traitement :

- un moyen de comparaison 12,
- deux diviseurs de courant 14,
- éventuellement un moyen suiveur 54.

Chacune des N-1 premières cellules réalise la fonction de transfert $i_s = |i_e|-I_e:2$ où les indices e correspondent aux courants reçus en entrée de la cellule et l'indice s correspond aux courants délivrés par la cellule. Chaque diviseur 14 a pour fonction de transfert $I_s = I_e:2$ où e représente le signal reçu en entrée et s le signal délivré en sortie. L'ensemble des diviseurs des N-1 premières cellules peut être réalisé simplement par deux réseaux résistifs R/2R, chaque réseau produisant une suite de courants dont les intensités sont en progression géométrique de raison 1/2.

La cellule terminale ne comprend qu'un moyen de comparaison 12 et au moins un moyen suiveur 54 mais pas de diviseur de courant. Elle ne comporte que deux entrées $e_1$ et $e_2$ recevant un courant analogique $i_e$ et son opposé $-i_e$.

Pour chacune des N-1 premières cellules, le moyen de comparaison 12 possède deux entrées reliées aux entrées $e_1$ et $e_2$ de la cellule et possède deux sorties reliées aux sorties $s_1$ et $s_2$ de la cellule. Chaque diviseur 14 a une entrée reliée à l'entrée $e_3$, $e_4$ de la cellule et une sortie reliée à la sortie $s_3$, $s_4$ de la cellule.

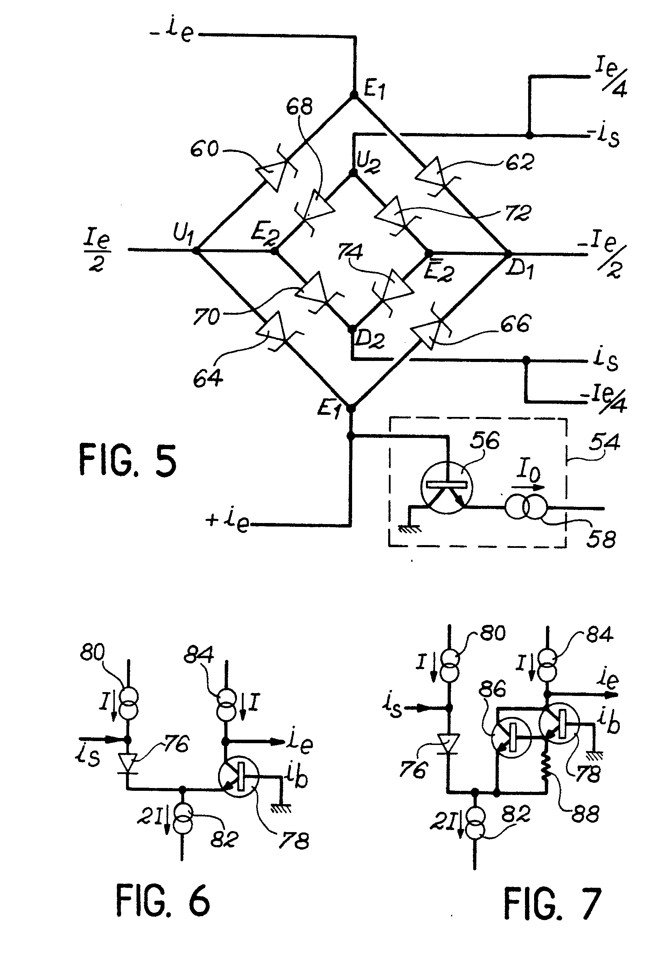

Les cellules sont disposées en cascade, c'est-à-dire que la sortie $s_i$, où $1 \leq i \leq 4$, d'une cellule est relié à l'entrée $e_i$ de la cellule suivante. Cette liaison peut être directe ou se faire par l'intermédiaire d'un moyen de liaison 8. On décrira en référence à la figure 5 un mode de réalisation du convertisseur de l'invention dans lequel deux cellules successives sont cascadées directement sans moyen de liaison entre elles.

Ce moyen de liaison 8 permet de limiter les excursions en tension entre les différentes cellules. Il comprend deux moyens 9a et 9b disposés respectivement entre les sorties $s_1$ et $s_2$ d'une cellule et les entrées $e_1$ et $e_2$ de la cellule suivante. Les sorties $s_3$ et $s_4$ d'une cellule sont reliées directement aux entrées $e_3$ et $e_4$ de la cellule suivante.

La cellule terminale et au moins chaque cellule, parmi les N-1 premières cellules, qui précède un moyen de liaison comprend en outre au moins un moyen suiveur 54 qui délivre au codeur numérique 10 un signal de tension numérique fonction du potentiel d'un noeud du moyen de comparaison de ladite cellule. L'ensemble des signaux délivrés par les cellules au codeur numérique constitue un codage numérique de la tension analogique V. Le codeur numérique 10 effectue un transcodage de ces signaux pour délivrer un signal numérique à N bits représentatif du niveau de la tension analogique V.

On va maintenant décrire en détail chacun des éléments de ce convertisseur analogique-numérique. Ces éléments seront représentés en technologie bipolaire. Ces figures peuvent être transposées intégralement avec des transistors à effet de champ (FET).

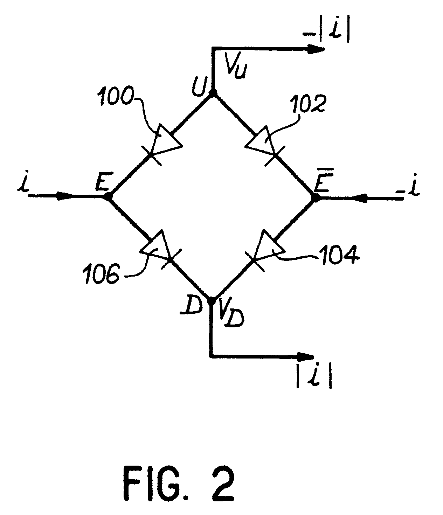

Le moyen de comparaison représenté sur la figure 2 est un pont de diodes 100, 102, 104 et 106. Les points d'entrée E et $\bar{E}$ du pont reçoivent respectivement un courant analogique i et son opposé -i. Les points de potentiel haut U et de potentiel bas D, qui sont respectivement le noeud relié aux cathodes de deux diodes et le noeud relié aux anodes de deux diodes, sont à des potentiels fixes $V_U$ et $V_D$.

En ces points apparaissent respectivement les courants $-|i|$ et $+|i|$. Ce circuit permet donc d'effectuer la valeur absolue d'un courant.

Il permet aussi de connaître le signe du courant i. En effet, supposons que le courant i soit positif. Alors la diode 106 est passante et le potentiel $V_E$ du point d'entrée E est égal à $V_S + V_D$, où $V_S$

est la tension de seuil de la diode 106. Si, au contraire, le courant i est négatif, la diode 100 est passante et le potentiel du point E est égal à $V_U - V_S$.

Le potentiel du point d'entrée E peut donc prendre deux valeurs qui correspondent, l'une à un courant i positif, l'autre à un courant i négatif.

On note que le point d'entrée $\bar{E}$ peut prendre les mêmes valeurs que le point d'entrée E. Son potentiel est le complémentaire de celui de E.

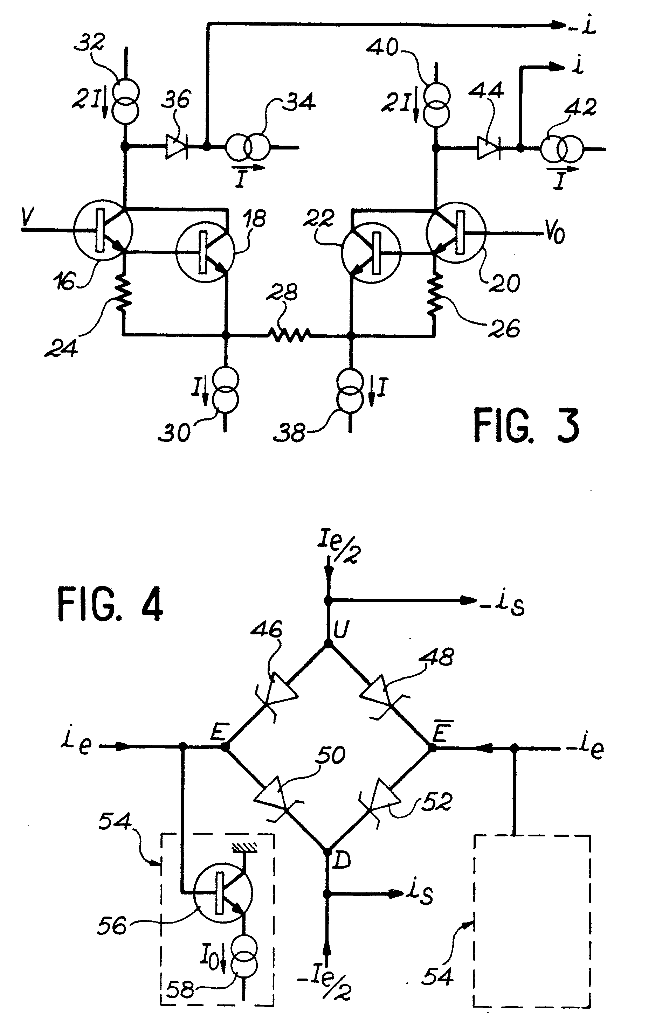

On a représenté sur la figure 3 un mode de réalisation de l'étage d'entrée 2 du convertisseur.

Cet étage d'entrée comprend un premier groupe de deux transistors 16 et 18 montés en Darlington, le transistor 16 recevant sur sa base le signal de tension analogique V, un deuxième groupe de deux transistors 20 et 22 montés en Darlington, le transistor 20 recevant sur sa base une tension de référence $V_O$. Des résistances identiques 24 et 26 relient respectivement les émetteurs des transistors 16 et 18 et les émetteurs des transistors 20 et 22. Une résistance 28 relie en outre les émetteurs des transistors 18 et 22. Le courant traversant cette résistance 28 est le courant analogique i correspondant à la tension analogique V.

Des sources de courant 30, 32, 34 sont également prévues de part et d'autre des transistors 16 et 18 pour transporter le courant traversant la résistance 28 vers le collecteur dudit transistor. La somme de ces courants est nulle, leur seul rôle est de polariser dans le bon sens les jonctions base-émetteur des transistors. La source de courant 30 délivre un courant -I vers les émetteurs des transistors 16 et 18 ; la source de courant 32 délivre un courant 2I vers les collecteurs desdits transistors et la source de courant 34 délivre un courant -I.

Une diode 36 est disposée entre le collecteur des transistors 16 et 18 et une sortie de l'étage d'entrée pour éviter la saturation du transistor 16. La diode 36 peut être soit constituée d'une ou plusieurs diodes en série, soit d'une diode Zener (montée en sens inverse) dans le but de réaliser un décalage de potentiel entre l'entrée de la première cellule et les collecteurs des transistors.

Symétriquement, une source de courant 38 délivre un courant -I vers les émetteurs des transistors 20 et 22, une source de courant 40 délivre un courant d'intensité 2I vers les collecteurs des transistors 20 et 22 et une source de courant 42 délivre un courant d'intensité -I vers une autre sortie de l'étage d'entrée. Une diode 44 identique à la diode 36 est disposée entre les collecteurs des transistors 20 et 22 et ladite autre sortie de l'étage d'entrée.

L'étage d'entrée représenté sur la figure 3 permet de convertir un signal de tension analogique V et un courant analogique i et son opposé -i en fonction du niveau de la tension V par rapport à la

gamme [$V_o$-$V_{ref}$, $V_o$ + $V_{ref}$].

Il est clair que l'invention n'est pas limitée au cas où le convertisseur analogique numérique comporte un étage d'entrée tel que représenté sur la figure 3 mais que l'on peut, sans sortir du cadre de l'invention, utiliser tout autre étage d'entrée convertissant un signal de tension analogique en un signal de courant analogique connu de l'homme de l'art.

On a représenté sur la figure 4 un premier mode de réalisation préféré du moyen de comparaison de chaque cellule du convertisseur analogique-numérique. Ce moyen de comparaison comprend un pont de diodes 46, 48, 50, 52 et deux moyens suiveurs 54.

Ces diodes sont de préférence des diodes dont ta tension de seuil $V_s$ est faible afin de limiter tes excursions en tension. Les diodes représentées sont de type Schottky dont la tension de seuil, sur silicium, est de 0,4 volt. Celles-ci sont d'autre part à la base du fonctionnement des dispositifs existant sur substrat GaAs.

Les points d'entrée symétriques du pont de diodes, notés E et $\overline{E}$, reçoivent respectivement le courant $i_e$ et le courant -$i_e$. Les points de potentiel haut et bas, notés U et D, du pont de diodes constituent les sorties du moyen de comparaison. Ces points sont à des potentiels fixes $V_U$ et $V_D$. Sur ces sorties sont délivrés respectivement les courants analogiques -$i_s$ et $i_s$ égaux respectivement à -|$i_e$|+ $I_e$:2 et |$i_e$|- $I_e$:2, les courants $I_e$:2 et -$I_e$:2 étant délivrés par les diviseurs associés à la cellule.

Pour la cellule terminale, qui ne comprend pas de diviseur, les courants $i_s$ et -$i_s$ délivrés sont égaux à |$i_e$| et -|$i_e$|. Ces courants ne sont pas utilisés. Seul le signe du courant $i_e$ appliqué sur l'entrée de cette cellule est pris en compte.

Pour chaque cellule, le signe du courant $i_e$ reçu est donné par le potentiel du point d'entrée E (ou du point d'entrée $\overline{E}$) comme on l'a indiqué en référence à la figure 2.

Les moyens suiveurs 54 comprenant un transistor 56 et une source de courant 58 permettent d'appliquer les potentiels des points d'entrée E et $\overline{E}$ sur les entrées du codeur numérique sans perturber le courant à l'entrée du pont.

Le bon fonctionnement du pont de diodes implique que soit satisfaite la relation $V_U$-$V_D$ < 2$V_S$, où $V_U$, $V_D$ et $V_S$ sont respectivement le potentiel au point haut U du pont de diodes, le potentiel au point bas D du pont de diodes et la tension de seuil d'une diode du pont. On a indiqué que le potentiel du pont d'entrée E pouvait prendre les deux valeurs $V_U$-$V_S$ et $V_D$+$V_S$. De manière préférée, pour limiter les excursions en tension, on impose que te potentiel $V_U$ du point haut U est égal au potentiel $V_D$ du point bas D augmenté du potentiel $V_S$ d'une diode. Ainsi les potentiels du point d'entrée E (ou du point d'entrée $\overline{E}$) sont $V_D$ et $V_D$ + $V_S$. L'excursion en tension est limitée à $V_S$.

Si au lieu de $V_U$ = $V_D$ + $V_S$ on choisit $V_U$ = $V_D$, les potentiels du point d'entrée E sont $V_D$-$V_S$ et $V_D$ + $V_S$. L'excursion en tension au point d'entrée du pont de diodes est deux fois plus importante que dans le cas précédent. L'avantage de limiter l'excursion en tension est de permettre la mise en cascade deux cellules directement sans intercaler entre elles un moyen de liaison. Ceci simplifie la réalisation du convertisseur et diminue sa consommation.

On a représenté sur la figure 5 deux moyens de comparaison mis directement en cascade sans moyen de liaison entre eux.

Le premier moyen de comparaison comprend un pont de quatre diodes 60, 62, 64 et 66. Le point d'entrée $E_1$ de ce pont reçoit le courant $i_e$ ; le point d'entrée symétrique $\overline{E}_1$ reçoit le courant -$i_e$. Les points de potentiel haut $U_1$ et bas $D_1$ constituent les sorties de la cellule. Ils reçoivent respectivement les courants $I_e$:2 et -$I_e$:2. Ces deux points sont respectivement reliés aux points $E_2$ et $\overline{E}_2$ du pont de diodes du moyen de comparaison suivant.

Ce dernier comprend quatre diodes 68, 70, 72 et 74. Il reçoit sur son entrée $E_2$ un courant -|$i_e$| + $I_e$:2 et sur son entrée $\overline{E}_2$ le courant opposé. Il délivre sur son point bas $D_2$ un courant égal à la valeur absolue du courant reçu sur ses points d'entrée, soit ||$i_e$|-$I_e$:2|et sur le point haut $U_E$ le courant opposé. Les courants de sortie i et -$i_s$ sont obtenus en ajoutant ($U_2$) et retranchant ($D_2$) le courant $I_e$:4.

Chaque cellule contribue pour un bit à la valeur numérique de la tension analogique V à numériser. Les deux cellules cascadées de la figure 5 contribuent donc pour deux bits à cette valeur. Ces deux bits sont représentés par le potentiel du point d'entrée $E_1$, ou du point d'entrée $\overline{E}_1$, qui peut prendre quatre valeurs.

En effet, on a vu à la figure 4 que le potentiel au point d'entrée du pont de diodes peut prendre les deux valeurs suivantes : $V_U$-$V_S$ et $V_D$+$V_S$. Dans le cas de la figure 5, les potentiels au point haut $U_1$ et au point bas $D_1$ peuvent eux-mêmes prendre deux valeurs puisqu'ils sont reliés aux points d'entrée $E_2$ et $\overline{E}_2$ du second pont de diodes. Les valeurs possibles du point de potentiel haut $U_1$ sont $V_{U2}$ - $V_S$ et $V_{D2}$ + $V_S$. Le potentiel du point bas $D_1$ peut prendre les deux mêmes valeurs.

Les quatre valeurs possibles du potentiel du point $E_1$ sont donc : $V_{U2}$ - 2$V_S$, $V_{D2}$, $V_{U2}$, $V_{D2}$ + 2$V_S$.

Les potentiels des points d'entrée $E_1$ et $\overline{E}_1$ sont traduits en deux signaux de tension quadrivalués par deux moyens suiveurs 54. On note qu'il est difficile de mettre un moyen suiveur sur le point d'entrée du second pont de diode en technologie bipolaire à cause d'un courant base non compensé. Ceci n'est pas gênant et permet au contraire de simplifier la réalisation tout en diminuant la consommation. De manière générale, un moyen suiveur n'est indispensable que pour les cellules qui suivent un moyen de liaison.

Pour limiter les excursions en tension, il faut imposer une différence de potentiel $V_{U2} - V_{D2}$ égale à $V_S$. Dans ce cas, les potentiels extrêmes du point d'entrée $E_1$ diffèrent de $3V_S$. L'excursion en tension est ici trois fois plus importante que dans le cas d'une seule cellule. Le calcul montre que si l'on désire cascader directement trois cellules, l'excursion en tension au point d'entrée de la première diode est de $7V_S$. Cette contrainte en tension est trop importante. Elle ne peut être levée qu'en faisant appel à des cellules actives transmettant le courant d'une cellule à la suivante sans transmettre les tensions.

Chaque moyen de liaison 8 (figure 2) comprend deux miroirs de courant 9a et 9b remplissant cette fonction. Ces miroirs de courant permettant de transmettre le courant analogique $i_s$ délivré par une cellule et son courant opposé. On a représenté sur la figure 6 un premier mode de réalisation de ce miroir de courant.

Ce miroir de courant comprend principalement une diode 76 recevant sur son anode (sur sa cathode dans le cas d'une diode Zener) le courant $i_s$ délivré par une cellule et un transistor 78 fonctionnant en base commune et dont l'émetteur est relié à la cathode de la diode (l'anode dans le cas d'une diode Zener) et dont le collecteur délivre le courant $i_e$ reçu par la cellule suivante. La diode permet de compenser la chute de tension introduite par le transistor 78. Un autre mode de réalisation des miroirs de courant sera de compenser cette chute en décalant les potentiels des bases des transistors 78. Cette solution permet de supprimer la diode 76, la source de courant 80 et de diminuer la source de courant 82 à la valeur I.

Le miroir de courant comprend en outre des sources de courants porteurs 80, 82 et 84, la source de courant 80 délivrant un courant $+I$ sur l'anode (cathode dans le cas d'une diode Zener) de la diode 76, la source de courant 82 délivrant un courant $-2I$ sur l'émetteur du transistor 78 et la source de courant 84 délivrant un courant $+I$ sur le collecteur dudit transistor. Ce mode de réalisation simple permet de délivrer un courant $i_e$ pratiquement égal au courant $i_s$ reçu en entrée tout en isolant les potentiels des cellules amont et aval.

En fait, le courant $i_e$ délivré est égal au courant $i_s$ diminué du courant de base $i_b$ du transistor 78. Le miroir de courant représenté schématiquement sur la figure 7 permet de rendre ce courant parasite quasi-constant. On le compense par le courant base du moyen suiveur. De la même façon, les courants base (quasi-constants) des transistors 16 et 20 de l'étage d'entrée sont compensés par les moyens suiveurs de la première cellule.

Sur cette figure, les éléments identiques à ceux de la figure 6 portent les mêmes références. Par rapport à celui de la figure précédente, le miroir de courant de la figure 7 comporte en outre un transistor 86 et une résistance 88. La base du transistor 86 est reliée à l'émetteur du transistor 78 et les collecteurs des deux transistors sont reliés entre eux. La résistance 88 relie les émetteurs des deux transistors.

L'intérêt de ce montage est que la tension aux bornes de la résistance 88 est quasi-constante : c'est la tension $V_{be}$ entre la base et l'émetteur du transistor 86. Dans le cas du silicium, cette tension est de 0,7 à 0,8 V environ. Le courant traversant la résistance 88 et donc le transistor 78 est donc lui aussi quasi constant. Il s'ensuit que le courant $i_b$ qui vient perturber la sortie du miroir de courant est lui aussi quasi-constant.

Considérant la figure 5 on remarque qu'une partie du courant $i_e$ reçu sur le point d'entrée $E_1$ du pont de diodes est appliquée sur la base du transistor 56. Pour éliminer la perturbation due au courant $i_b$ du miroir de courant de la figure 7, il suffit que le courant arrivant sur la base du transistor 56 (figure 5) soit égal à $i_b$. Ceci est réalisé si le courant traversant la résistance 88 est égal à la source de courant 58 reliée à l'émetteur du transistor 56.

Ainsi, par simple ajustage de la source de courant 58 par rapport à la résistance 88, le courant analogique reçu sur le point d'entrée d'un pont de diodes d'une cellule est strictement égal au courant analogique délivré par le pont de diodes de la cellule précédente. Par ailleurs, à la condition de fixer la tension de base du transistor 78 de façon à ne pas saturer le miroir de courant de la cellule précédente, il est possible de supprimer la diode 76.

Ce montage de type Darlington est inutile dans le cas d'une réalisation en MOS ou MES.

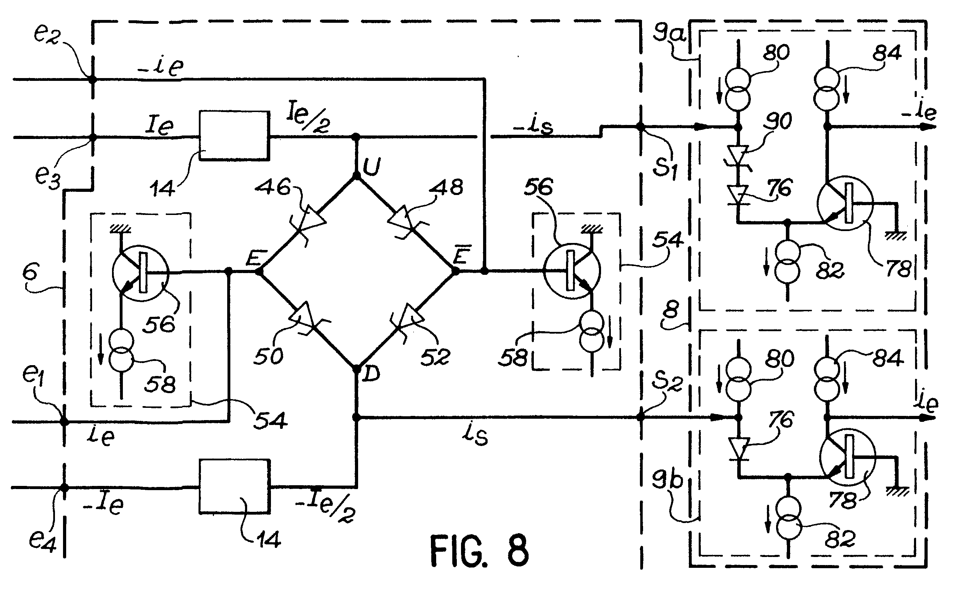

La figure 8 illustre un mode de réalisation du moyen de comparaison 12 d'une cellule et des relations de ce moyen de comparaison avec les miroirs de courant du moyen de liaison.

Le moyen de comparaison 12 est constitué d'un pont de diodes identique à celui décrit en référence à la figure 4 et de deux moyens suiveurs 54 identiques à ceux décrits en référence aux figures 4 et 5 et reliés à chacun des points d'entrée E et $\overline{E}$ du pont de diodes. Il est clair que l'utilisation de deux moyens suiveurs n'est pas nécessaire puisque l'information numérique recherchée correspond aussi bien au potentiel du point d'entrée E qu'au potentiel du point d'entrée $\overline{E}$. Cependant, l'utilisation de deux moyens suiveurs permet d'éliminer le courant perturbateur $i_b$ amené, soit par les miroirs de courant décrits en référence à la figure 7, soit par les transistors 16 et 20 de l'étage d'entrée dans le cas de la première cellule.

Les miroirs de courant 9a et 9b recevant respectivement les courants délivrés par le point haut U et par le point bas D du pont de diodes ont déjà été décrits en référence aux figures 6 et 7. On note qu'il a été adjoint au miroir de courant 9a relié au point de potentiel haut U du pont de diodes une diode supplémentaire 90 disposée en série avec la diode 76, cette diode 90 étant du même type que les diodes du pont. Cette diode permet de réhausser d'une valeur $V_S$ le potentiel du point haut U du pont et d'avoir ainsi une différence de potentiel $V_U - V_D = V_S$ qui permet, ainsi qu'on l'a mentionné plus haut, de limiter les excursions en tension sur les points d'entrée E et $\overline{E}$ du pont de diodes.

Il est également possible pour réhausser le potentiel du point U par rapport à D de décaler les potentiels des bases de transistors 78 des miroirs de courant respectifs.

Le convertisseur analogique-numérique qui vient d'être décrit peut être réalisé aussi bien en technologie bipolaire qu'en technologie FET sur Si ou sur AsGa, voire plus généralement sur tout substrat semi-conducteur.

En technologie FET le courant de grille $i_G$ des transistors est pratiquement nul (courant de Schottky de $10^{-9}$ A en inverse en MES et courant Tunnel en MOS inférieur à $10^{-12}$ A). Il n'est alors pas nécessaire d'associer un moyen suiveur à chaque miroir de courant, ce qui en bipolaire est indispensable. Par contre, il est possible dans ces technologies d'associer un moyen suiveur aux points $E_2$ et $\overline{E}_2$ de la double cellule de la figure 5.

## Revendications

1. Convertisseur analogique-numérique très rapide de type dichotomique pour convertir un signal de tension analogique V contenu dans un intervalle de tension $[V_O-V_{ref}, V_O+V_{ref}]$ en une valeur numérique sur N bits, ledit convertisseur comprenant :
   - un étage d'entrée (2) pour convertir le signal V en un courant i, fonction de $V-V_O$, et pour produire son opposé -i;
   - une source (4) de courant pour délivrer en fonction de $V_{ref}$ un courant de référence I, et son inverse -I;
   - N-1 cellules identiques ($6_1,..., 6_{N-1}$) en série, chacune recevant sur une entrée $e_1$ un courant analogique $i_e$ qui est égal à i pour la première, sur une entrée $e_2$ le courant analogique opposé $-i_e$, sur une entrée $e_3$ un courant de référence $I_e$ qui est égal à I pour la première et sur une

entrée $e_4$ le courant de référence opposé $-I_e$, chaque cellule comportant deux diviseurs de courant (14), un moyen (12) de comparaison à zéro et d'obtention de la valeur absolue du potentiel d'un point d'entrée (E, $\overline{E}$), et un moyen suiveur (54) pour les cellules reliées en amont à une autre cellule pour délivrer un signal de tension numérique fonction dudit potentiel d'un point d'entrée (E, $\overline{E}$), chaque cellule délivrant à une sortie $s_1$ un courant $i_s = |i_e| - I_e : 2$, à une sortie $s_2$ le courant opposé $-i_s$, à une sortie $s_3$ le courant $I_s = I_e : 2$ et à une sortie $S_4$ le courant opposé $-I_s$, ledit moyen (12) de comparaison à zéro et d'obtention de la valeur absolue du potentiel d'un point d'entrée (E, $\overline{E}$) de chaque cellule comprenant un pont de diodes (100, 102, 104, 106) dont les points de potentiels haut et bas sont respectivement à un potentiel fixe $V_U$ et $V_D$ qui vérifient $V_U - V_D < 2.V_S$, où $V_S$ est la tension de seuil d'une diode du pont, et dont tes points d'entrée (E, $\overline{E}$) reçoivent respectivement le courant $i_e$ et son opposé $-i_e$, le résultat de la comparaison à zéro étant indiqué par le potentiel d'un point d'entrée (E, $\overline{E}$) et les courants $|i|$ et $-|i|$ apparaissant respectivement sur les points de potentiel bas et haut du pont;
   - une cellule terminale ($6_N$) comprenant un moyen de comparaison à zéro et d'obtention de la valeur absolue du potentiel d'un point d'entrée (E, $\overline{E}$) et au moins un moyen suiveur (54);
   - un codeur numérique (10) recevant lesdits signaux de tension numérique délivrés par lesdites cellules et délivrant N signaux binaires ($b_1,..., b_N$) représentant la valeur numérisée dudit signal de tension analogique V;

caractérisé en ce qu'il comporte un nombre n de moyens de liaison (8) à base de miroirs de courant, où $1 \leq n \leq N-1$ chaque moyen de liaison (8) étant disposé respectivement entre les sorties $s_1$ et $s_2$ d'une cellule et les entrées $e_1$ et $e_2$ de la cellule suivante, afim de transmettre le courant $i_s$ et son opposé $-i_s$ délivrés par une cellule à la cellule suivante en isolant les potentiels des moyens (12) de comparaison à zéro et d'obtention de la valeur absolue du potentiel d'un point d'entrée (E, $\overline{E}$) desdites cellules, les sorties $s_3$ et $s_4$ d'une cellule étant reliées directement aux entrées $e_3$ et $e_4$ de la cellule suivante.

2. Convertisseur analogique-numérique selon la revendication 1 , caractérisé en ce que chaque moyen de liaison (8) comprend deux miroirs de courent (9a,9b) reliés au point de potentiel haut et au point de potentiel bas du pont de diodes.

3. Convertisseur analogique-numérique selon la revendication 2, caractérisé en ce que chaque miroir de courant (9a, 9b) comporte un transistor (78) dont l'émetteur et le collecteur constituent respectivement l'entrée et la sortie.

4. Convertisseur analogique-numérique selon la revendication 3, caractérisé en ce que chaque miroir de courant comprend en outre une diode (76) présentant une chute de tension entre l'entrée du miroir de courant et l'émetteur du transistor (78).

5. Convertisseur analogique-numérique selon l'une quelconque des revendications 3 et 4, caractérisé en ce que chaque miroir de courant comprend en outre un second transistor (86) monté en Darlington avec le transistor (78), une résistance (88) étant disposée entre les émetteurs desdits transistors.

6. Convertisseur analogique-numérique selon l'une quelconque des revendications 1 à 5, caractérisé en ce qu'il comprend N-1 moyens de liaison (8) intercalés entre les N cellules.

7. Convertisseur analogique-numérique selon l'une quelconque des revendications 1 à 5, caractérisé en ce qu'il comprend un moyen de liaison entre chaque cellule de rang pair et la cellule suivante.

8. Convertisseur analogique-numérique selon l'une quelconque des revendications 1 à 7, caractérisé en ce que chaque cellule ($6_1$, ..., $6_{N-1}$) suivie d'un moyen de liaison (18) comprend au moins un moyen suiveur pour délivrer au codeur numérique (10) un signal de tension fonction du potentiel d'un point d'entrée (E, $\overline{E}$) du moyen de comparaison à zéro et d'obtention de la valeur absolue de ladite cellule.

9. Convertisseur analogique-numérique selon l'une quelconque des revendications 1 à 8, caractérisé en ce que la différence de potentiel $V_U$-$V_D$ entre les points haut et bas du point de diodes de chaque moyen de comparaison à zéro et d'obtention de la valeur absolue est égale à la tension de seuil $V_S$ d'une diode du pont.

10. Convertisseur analogique-numérique selon l'une quelconque des revendication 1 à 9, caractérisé en ce que chaque diode du pont de diodes de chaque moyen de comparaison à zéro et d'obtention de la valeur absolue est une diode Schottky.

11. Convertisseur analogique-numérique selon l'une quelconque des revendications 1 à 10, caractérisé en ce qu'il comporte en outre en entrée un échantillonneur-bloqueur.

**Claims**

1. Very high speed analog - digital converter of the dichotomy type for converting an analog voltage signal V contained in a voltage interval [$V_O$-$V_{ref}$, $V_O$ + $V_{ref}$] and a digital value on N bits, said converter comprising:

   - an input stage (2) for converting the signal V into a current i, which is a function of V-$V_O$, and for producing its opposite -i;
   - a current source (4) of reference I for supplying, as a function of $V_{ref}$, a current and its inverse -I
   - N-1 identical cells ($6_1$,..., $6_{N-1}$) in series, each receiving on an input $e_1$ an analog current $i_e$ which is equal to i for the first, on an input $e_2$ the opposite analog current -$i_e$, on an input $e_3$ a reference current $I_e$, which is equal to I for the first and on an input $e_4$ the opposite reference current -$I_e$, each cell having two current dividers (14), a means (12) for zero comparison and obtaining the absolute value of the potential of an input point (E, $\overline{E}$) and a follower means (54) for the cells connected upstream to another cell for supplying a digital voltage signal, which is a function of said potential of an input point (E, $\overline{E}$), each cell supplying at an output $s_1$ a current $i_s$ = |$i_e$|-$I_e$:2, at an output $s_2$ the opposite current -$i_s$, at an output $s_3$ the current $I_s$ = $I_e$:2 and at an output $S_4$ the opposite current -$I_s$, said means (12) for zero comparison and for obtaining the absolute value of the potential of an input point (E, $\overline{E}$), each cell having a diode bridge (100, 102, 104, 106), whose high and low potential points are respectively at a fixed potential $V_U$ and $V_D$ proving $V_U$-$V_D$(2.$V_S$, in which $V_S$ is the threshold voltage of one diode of the bridge and whose input points (E, $\overline{E}$) respectively receive the current $i_e$ and its opposite -$i_e$, the result of the zero comparison being indicated by the potential of an input point (E, $\overline{E}$) and the currents |i| and -|i| appearing respectively on the high and low potential points of the bridge,

- a terminal cell (6$_N$) incorporating a means for the zero comparison and obtaining the absolute value of the potential of an input point (E, $\overline{E}$) and at least one follower means (54),
- a digital coder (10) receiving the said digital voltage signals supplied by the cells and supplying N binary signals (b$_1$...., b$_N$) representing the digitized value of said analog voltage signal V,

characterized in that it also has a number n of linking means (8) based on current mirrors, in which 1≤n≤N-1, each linking means (8) being positioned between respectively the outputs s$_1$ and s$_2$ of a cell and the inputs e$_1$ and e$_2$ of the following cell, so as to transmit the current i$_s$ and its opposite -i$_s$ supplied by a cell to the following cell by isolating the potentials of the means (12) for zero comparison and obtaining the zero value of the potential of an input point (E, $\overline{E}$) from said cells, the output s$_3$ and s$_4$ of a cell being directly connected to the inputs e$_3$ and e$_4$ of the following cell.

2. Analog - digital converter according to claim 1, characterized in that each linking means (8) comprises two current mirrors (9a, 9b) connected to the high potential point and to the low potential point of the diode bridge.

3. Analog - digital converter according to claim 2, characterized in that each current mirror (9a, 9b) has a transistor (78), whose emitter and collector respectively constitute the input and output.

4. Analog - digital converter according to claim 3, characterized in that each current mirror also comprises a diode (76) having a voltage drop between the current mirror input and the transistor (78) emitter.

5. Analog - digital converter according to either of the claims 3 and 4, characterized in that each current mirror also comprises a second transistor (86) in Darlington connection with the transistor (78), a resistor (88) being placed between the emitters of said transistors.

6. Analog - digital converter according to any one of the claims 1 to 5, characterized in that it comprises N-1 linking or connecting means (8) placed between the N cells.

7. Analog - digital converter according to any one of the claims 1 to 5, characterized in that it comprises a linking means between each cell of even order and the following cell.

8. Analog - digital converter according to any one of the claims 1 to 7, characterized in that each cell (6$_1$ ... 6$_{N-1}$) followed by a linking means (18) comprises at least one follower means for supplying the digital coder (10) with a voltage signal, which is a function of the potential of an input point (E, $\overline{E}$) of the means for zero comparison and obtaining the absolute value of said cell.

9. Analog - digital converter according to any one of the claims 1 to 8, characterized in that the potential difference V$_U$-V$_D$ between the high and low points of the diode bridge of each means for the zero comparison and obtaining of the absolute value is equal to the voltage threshold V$_S$ of one diode of the bridge.

10. Analog - digital converter according to any one of the claims 1 to 9, characterized in that each diode of the diode bridge of each means for the zero comparison and obtaining of the absolute value is a Schottky diode.

11. Analog - digital converter according to any one of the claims 1 to 10, characterized in that it also comprises at the input a sample and hold circuit.

## Patentansprüche

1. Analog/Digital-Wandler sehr hoher Geschwindigkeit vom dichotomischen Typ zum Umwandeln eines analogen Gleichspannungssignals V in einem Spannungsintervall [V$_O$-V$_{ref}$, V$_O$+V$_{ref}$] in einen digitalen Wert mit N-Bits, enthaltend:

eine Eingangsstufe (2) zum Umwandeln des Signals V in einen Strom i in Abhängigkeit von V-V$_O$ und zum Erzeugen seines Kehrwertes -i;

eine Stromquelle (4) zum Liefern eines Bezugsstroms I in Abhängigkeit von V$_{ref}$ und seines Kehrwertes -I;

N-1 identische Zellen (6$_1$,..., 6$_{N-1}$) in Serie, die jeweils an einem Eingang e$_1$ einen Analogstrom i$_e$ aufnehmen, der gleich i für die erste ist, an einem Eingang e$_2$ den entgegengesetzten Analogstrom (-i$_e$) aufnehmen, an einem Eingang e$_3$ einen Bezugsstrom I$_e$ aufnehmen, der gleich I ist für die erste und an einem Eingang e$_4$ den entgegengesetzten Bezugsstrom -I$_e$ aufnehmen, wobei jede Zelle enthält:

zwei Stromteiler (14), eine Einrichtung (12) zum Vergleichen mit Null und zum Erhalten des Absolutwertes des Potentials eines Eingangspunktes (E, $\overline{E}$) und eine Folgeeinrichtung (54) für die Zellen, die stromaufwärts einer weiteren Zelle angeschlossen sind, um ein digitales Spannungssignal in Abhängigkeit von dem genannten Potential eines Eingaspunktes (E, $\overline{E}$) zu liefern, wobei jede Zelle an einem Ausgang $s_1$ einen Strom $i_s = |i_e| - I_e : 2$ liefert, an einem Ausgang $s_2$ den entgegengesetzten Strom $-i_s$ liefert, an einem Ausgang $s_3$ den Strom $I_s = I_e : 2$ liefert und an einem Ausgang $s_4$ den entgegengesetzten Strom $-I_s$ liefert, wobei die Einrichtung (12) zum Vergleichen mit Null und zum Erhalten des Absultwertes des Potentials eines Eingangspunktes (E, $\overline{E}$) jeder Zelle eine Diodenbrücke (100, 102, 104, 106) enthält, deren Punkte hohen und niedrigen Potentials jeweils mit einem Festpotential $V_U$ und $V_D$ verbunden sind, die $V_U - V_D$ kleiner $2 \times V_S$ gehorchen, wobei $V_S$ die Schwellenspannung einer Diode der Brücke ist, und deren Eingangspunkte (E, $\overline{E}$) den Strom $I_e$ bzw. seinen entgegengesetzten Wert $-i_e$ aufnehmen, wobei das Ergebnis des Vergleichs mit Null durch das Potential eines Eingangspunktes (E, $\overline{E}$) und die Ströme $|i|$ und $-|i|$ angegeben wird, die jeweils an den Punkten hohen und niedrigen Potentials der Brücke auftreten;

eine Anschlußzelle ($6_N$), die eine Einrichtung zum Vergleichen mit Null und zum Erzielen des Absolutwertes des Potentials eines Eingangspunktes (E, $\overline{E}$) und wenigstens eine Folgeeinrichtung (54) enthält;

einen digitalen Kodierer (10), der die genannten digitalen Spannungssignale aufnimmt, die von den genannten Zellen geliefert werden und der N binäre Signale ($b_1$,..., $b_N$) abgibt, die den digitalen Wert des analogen Spannungssignals V repräsentieren;

dadurch gekennzeichnet, daß er eine Anzahl n Verbindungseinrichtungen (8) von Stromspiegelungsart enthält, wobei $1 \leqq n \leqq N-1$ ist, wobei jede Verbindungseinrichtung (8) jeweils zwischen den Ausgängen s1 und s2 einer Zelle und den Eingängen e1 und e2 der nachfolgenden Zelle angeordnet ist, um den Strom $i_s$ und seinen Kehrwert $-i_s$ zu übertragen, die von einer Zelle zur nachfolgenden Zelle übertragen werden, wobei die Potentiale der Einrichtung (12) zum Vergleichen mit Null und zum Erhalten des Absolutwertes des Potentials eines Eingangspunktes (E, $\overline{E}$) der genannten Zellen, die Ausgänge s3 und s4 einer Zelle direkt mit den Eingängen e3 und e4 der nachfolgenden Zelle verbunden sind.

2. Analog/Digital-Wandler nach Anspruch 1, dadurch gekennzeichnet, daß jede Verbindungseinrichtung (8) zwei Stromspiegel (9a, 9b) enthält, die mit den Punkten hohen und niedrigen Potentials der Diodenbrücke verbunden sind.

3. Analog/Digital-Wandler nach Anspruch 2, dadurch gekennzeichnet, daß jeder Stromspiegel (9a, 9b) einen Transistor (78) enthält, dessen Emitter und dessen Kollektor jeweils den Eingang und den Ausgang bilden.

4. Analog/Digital-Wandler nach Anspruch 3, dadurch gekennzeichnet, daß jeder Stromspiegel weiterhin eine Diode (76) enthält, die einen Spannungsabfall zwischen dem Eingang des Stromspiegels und dem Emitter des Transistors (78) aufweist.

5. Analog/Digital-Wandler nach einem der Ansprüche 3 und 4, dadurch gekennzeichnet, daß jeder Stromspiegel weiterhin einen zweiten Transisotor (86) enthält, der mit dem Transistor (78) in Darlington-Schaltung geschaltet ist, wobei ein Widerstand (88) zwischen den Emittern der Transistoren angeordnet ist.

6. Analog/Digital-Wandler nach einem der Ansprüche 1 bis 5, dadurch gekennzeichnet, daß er N-1 Verbindungseinrichtungen (8) enthält, die zwischen die N Zellen geschaltet sind.

7. Analog/Digital-Wandler nach einem der Ansprüche 1 bis 5, dadurch gekennzeichnet, daß er eine Verbindungseinrichtung zwischen jeder geradzahligen Zelle und der nachfolgenden Zelle enthält.

8. Analog/Digital-Wandler nach einem der Ansprüche 1 bis 7, dadurch gekennzeichnet, daß jede Zelle ($6_1$,..., $6_{N-1}$), der eine Verbindungseinrichtung (18) folgt, wenigstens eine Folgeeinrichtung enthält, um an den digitalen Kodierer (10) ein Spannungssignal in Abhängigkeit von dem Potential eines Eingangspunktes (E, $\overline{E}$) der Einrichtung zum Vergleichen mit Null und zum Erhalten des Absolutwerts der Zelle aufweist.

9. Analog/Digital-Wandler nach einem der Ansprüche 1 bis 8, dadurch gekennzeichnet, daß die Potentialdifferenz $V_U - V_D$ zwischen den Punkten hohen und tiefen Potentials der Diodenbrücke einer jeden Einrichtung zum Vergleichen mit Null und zum Erhalten des Absolutwertes gleich der Schwellenspannung $V_S$ einer Diode der Brücke ist.

10. Analog/Digital-Wandler nach einem der Ansrprüche 1 bis 9, dadurch gekennzeichnet, daß jede Diode der Diodenbrücke jeder Einrichtung zum Vergleichen mit Null und zum Erhalten des Absolutwertes eine Schottky-Diode ist.

11. Analog/Digital-Wandler nach einem der Ansprüche 1 bis 10, dadurch gekennzeichnet, daß er weiterhin am Eingang einen Probenehmer-Sperrer enthält.

FIG. 1

EP 0 161 963 B1

FIG. 2

FIG. 3

FIG. 4

FIG. 5

FIG. 6

FIG. 7

FIG. 8